# EUROPÄISCHE PATENTANMELDUNG

(11) **EP 2 317 606 A2**
(43) Veröffentlichungstag der Anmeldung: **04.05.2011**
(21) Anmeldenummer: 10188970.7
(22) Anmeldetag: 27.10.2010
(51) Int. Cl.: H01R 11/00, G01R 1/04

(54) **Prüfungskontakt für Starter**

(30) Priorität: 29.10.2009 DE 102009046150
(71) Anmelder: Robert Bosch GmbH, 70442 Stuttgart (DE)
(72) Erfinder: Mundhenke, Klaus, 31036, Eime (DE); Koch, Benjamin, 30974, Wennigsen (DE)

(57) **Zusammenfassung**

Der Gegenstand der vorliegenden Erfindung betrifft eine Prüfungseinrichtung (10) zur elektrischen Prüfung von in eine Längsrichtung (L) hervorragenden Kontakten, insbesondere zur Leistungsprüfung bei Startern, umfassend einen Kontaktkörper (2) mit einer Kontaktausnehmung (5) zur Aufnahme des Kontakts, wobei der Kontakt zur Prüfung über Klemmmittel (3) in dem Kontaktkörper (2) eingeklemmt ist, wobei die Klemmmittel (3) in Längsrichtung (L) relativ zu dem Kontakt und/oder dem Kontaktkörper (2) bewegbar sind und dadurch eine klemmende Kontaktierung quer zu der Längsrichtung (L) bewirken, sodass eine Klemmung nach Aufnahme des Kontakts bewirkt ist. Weiter betrifft der Gegenstand der vorliegenden Erfindung ein Verfahren zum elektrischen Prüfen von in eine Längsrichtung (L) hervorragenden Kontakten, wobei Klemmmittel (3) in Längsrichtung (L) relativ zu dem Kontakt und/oder dem Kontaktkörper (2) bewegt werden, um durch eine Bewegung der Klemmmittel (3) eine klemmende Kontaktierung des aufgenommenen Kontakts quer zu der Längsrichtung (L) zu bewirken. Zudem betrifft der Gegenstand der vorliegenden Erfindung die Verwendung der Prüfungseinrichtung (10) zur elektrischen Prüfung von in eine Längsrichtung (L) hervorragenden Kontakten, insbesondere zur Leistungsprüfung bei Startern.

## Beschreibung

Die Erfindung betrifft eine Prüfungseinrichtung zur elektrischen Prüfung von in eine Längsrichtung hervorragenden Kontakten, insbesondere zur Relaisprüfung bei Startern, gemäß dem Oberbegriff des Anspruchs 1.

Weiter betrifft die Erfindung ein Verfahren zum elektrischen Prüfen von in eine Längsrichtung hervorragenden Kontakten, insbesondere zur Leistungsprüfung bei Startern, gemäß des Anspruchs 12.

Zudem betrifft die Erfindung die Verwendung einer Prüfungseinrichtung nach dem Anspruch 13.

### Stand der Technik

Die Erfindung geht aus von einem Prüfungssystem für Starter oder Startermotoren, genauer für Starterrelais, sowie einem Verfahren zur Prüfung von Startern und einer Verwendung einer Prüfungseinrichtung nach Gattung der unabhängigen Ansprüche.

Gegenstand der vorliegenden Erfindung sind Prüfsysteme zur Kontrolle von Startern im eingebauten Zustand, im ausgebauten Zustand und während der Herstellung und Montage.

Aus dem Stand der Technik sind Prüfsysteme für das Relais eines Starters bekannt. Die Prüfung erfolgt derart, dass die Kontakte des Relais mit dem Prüfsystem verbunden werden und ein Stromfluss von dem Kontakt zu dem Prüfsystem oder umgekehrt erfasst wird.

Kontakte für derartige Prüfungssysteme weisen eine in Längsrichtung hervorragende, längliche Form, meist in Form von Zylinderstiften oder Zungen auf. Bei den bekannten Prüfungssystemen werden die Kontakte über stirnseitig anliegende Bolzen mit dem Prüfungssystem verbunden. Nach Herstellung einer derartigen Verbindung wird der Starter geprüft, indem beispielsweise über ein Relais das Ritzel vorgespurt wird und ein Startermotorstrom geschaltet wird.

### Offenbarung der Erfindung

Die erfindungsgemäße Prüfungseinrichtung mit den Merkmalen des Hauptanspruches oder des entsprechenden nebengeordneten Anspruches hat dem gegenüber den Vorteil, dass eine Verbindung von Starter und Prüfungseinrichtung innerhalb einer Taktzeit von sechs Sekunden sicher hergestellt ist. Die Prüfungseinrichtung ist zur elektrischen Prüfung von Starterrelais ausgebildet, indem zum Beispiel ein Strom von der Prüfungseinrichtung zum Starter übertragen wird. Hierzu weist die Prüfungseinrichtung einen Kontaktkörper auf, der in elektrisch leitfähige Verbindung mit einem Kontakt des Relais gebracht wird. Der Kontakt des Relais kann von einer Kontur umgeben sein und beispielsweise als Kontakt eines Steckers ausgebildet sein. Zur Herstellung einer sicheren Verbindung sind bewegbar, insbesondere verschiebbar gelagerte Klemmmittel vorgesehen. Diese bewirken bei einer Bewegung ein sicheres Klemmen von Kontakt und Kontaktkörper. Somit umfasst die Prüfungseinrichtung zur elektrischen Prüfung von in eine Längsrichtung hervorragenden Kontakten, insbesondere zur Leistungsprüfung bei Startern, einen Kontaktkörper zum Kontaktieren mit dem Kontakt. Der Kontaktkörper weist bevorzugt eine Kontaktausnehmung zur Aufnahme des Kontakts und Klemmmittel auf, wobei der Kontakt zur Prüfung über die Klemmmittel in dem Kontaktkörper eingeklemmt ist. Die vorgesehenen Klemmmittel sind in Längsrichtung relativ zu dem Kontakt und/oder dem Kontaktkörper bewegbar, insbesondere bewegbar gelagert, um durch eine Bewegung der Klemmmittel eine klemmende Kontaktierung des aufgenommenen Kontakts quer zu der Längsrichtung zu bewirken. Ein Kontaktbereich zwischen dem Kontakt des Starters und dem Kontaktkörper der Prüfungseinrichtung weist eine entsprechend große Kontaktfläche auf, sodass auch Ströme bis zu 1000 A und darüber hinaus sicher und ohne Versagen übertragbar sind. Zudem weist der Kontaktkörper vorzugsweise entsprechende Aufweitungen auf, die eine Verbindung auch bei einer ungenauen Relaislage in Relation zu dem Kontaktkörper ermöglicht. Beispielsweise ist das Relais in einem Werkzeugträger aufgenommen, wobei die Relaislage von einer Vorgabe abweicht. Durch eine entsprechende Aufweitung, beispielsweise eine Kegelform, werden Lageungenauigkeiten toleriert und ausgeglichen. Auch wenn ein Starter sich in einer Anlaufphase, beispielsweise aufgrund von Reaktionsmomenten bewegt, kann es zu Lageänderungen des Relais kommen, welche durch eine Aufweitung des Kontaktkörpers tolerierbar sind. Durch eine an die Kontur des Kontaktes angepasste Aufnahmekontur ist eine große Kontaktfläche zwischen Kontaktkörper und Kontakt realisiert, sodass es bei hohen Stromdichten nicht aufgrund zu geringer Kontaktflächen zu Versagen kommt. Somit lassen sich mit der erfindungsgemäßen Prüfungseinrichtung auch hohe Stromstärken zuverlässig übertragen. Durch geeignete Klemmmittel und die Aufweitung ist eine schnelle und zuverlässige Verbindung zwischen Kontakt und Kontaktkörper herstellbar, sodass schnelle Taktzeiten von unter 6 Sekunden realisierbar sind. Durch eine kleine und kompakte Bauform der Prüfungseinrichtung erfordert diese wenig Bauraum.

Durch die in den abhängigen Ansprüchen aufgeführten Maßnahmen sind vorteilhafte Weiterbildungen und Verbesserungen der in den unabhängigen und nebengeordneten Ansprüchen vorgegebenen Vorrichtungen möglich.

In einer vorteilhaften Ausgestaltung ist deshalb vorgesehen, dass der Kontaktkörper eine Kontaktausnehmung zur Aufnahme des Kontakts aufweist, wobei die Kontaktausnehmung als Innenkontaktausnehmung ausgebildet ist, welche den Kontakt bei Prüfung umfänglich zumindest teilweise umgibt. Auf diese Weise ist der Kontakt bei einer Prüfung gegenüber äußeren Einflüssen durch den Kontaktkörper geschützt. Die Innenkontaktausnehmung kann als Schlitz, als Bohrung und dergleichen ausgebildet sein. Bevorzugt ist der Kontaktkörper zweiteilig ausgebildet mit zwei etwa achssymmetrischen Körperteilen. Die Innenkontaktausnehmung ist entsprechend um eine Symmetrieachse ausgebildet, beispielsweise durch Fräsung, Ausnehmung oder dergleichen.

Zudem ist es vorteilhaft, dass die Innenkontaktausnehmung eine Innenkontur aufweist, die ähnlich zu einer Außenkontur des Kontakts ausgebildet ist, sodass der Kontakt unter Spiel in der Innenkontur aufnehmbar ist. Ähnlich im Sinne der Erfindung bedeutet, dass die Konturen im Wesentlichen gleich ausgebildet sind, wobei lediglich im Maßstab Unterschiede vorhanden sind, sodass die Innenkontur im Wesentlichen parallel beabstandet zu der Außenkontur anordenbar ist, das heißt, mit einem in einer Spaltbreite etwa konstanten Spalt. Auf diese Weise ist der Kontakt einfach und ohne Beschädigung seiner Oberflächen in der Ausnehmung des Kontaktkörpers aufnehmbar.

In einer vorteilhaften Ausgestaltung ist vorgesehen, dass die Kontaktausnehmung an einem dem Kontakt zugewandten Stirnbereich eine Aufweitung zur Aufnahme des Kontakts aufweist. Durch die Aufweitung, die beispielsweise als sich kegelförmig erweiternder Bereich ausgebildet sein kann, ist ein leichtes Einführen des Kontakts in die Aufnahme realisierbar. Lagetoleranzen des Kontakts sind über die Aufweitung ausgleichbar. Die Aufweitung dient somit als Einführhilfe zur einfachen Positionierung des Kontakts in der Aufnahme.

In einer besonders bevorzugten Ausführungsform weist der Kontaktkörper einen elastischen Abschnitt im Bereich der Kontaktaufnahme auf, um den aufgenommenen Kontakt bei Betätigung und daraus resultierend einer Verformung zu klemmen. Der elastische Bereich ist in einer Ausführungsform durch Materialschwächung ausgeführt, beispielsweise durch dünnwandigeres Material oder durch Schlitze oder Einkerbungen. In einer anderen Ausführungsform weist der Kontaktkörper in dem elastischen Abschnitt ein gegenüber den anderen Abschnitten ein elastischeres Material auf. Entsprechend ist in einer Ausführungsform der Kontaktkörper einteilig ausgebildet. In andere Ausführungsformen ist der Kontaktkörper mehrteilig ausgebildet, beispielsweise mit einem elastischen Abschnitt aus Moosgummi oder dergleichen. In anderen Ausführungsformen ist eine Kombination aus unterschiedlichen elastischen Materialien und Materialschwächungen realisiert.

In einer vorteilhaften Ausgestaltung ist deshalb vorgesehen, dass der Kontaktkörper und die Klemmmittel über mindestens eine schräge Fläche an dem elastischen Abschnitt miteinander kontaktierend gekoppelt sind, sodass durch eine Relativbewegung der Klemmmittel zu dem Kontaktkörper eine Klemmung des aufgenommenen Kontakts bewirkt oder aufgehoben ist. In einer Ausführungsform weist das Klemmmittel eine Art schiefe Ebene auf, die durch Bewegung in Längsrichtung, das heißt in Richtung der Erstreckung der Aufnahme und somit des Kontakts, eine Klemmkraft quer zu der Längsrichtung auf den Kontaktkörper ausübt. Dieser überträgt die Klemmkraft aufgrund des elastischen Abschnitts auf den Kontakt, sodass der Kontakt entsprechend geklemmt ist. In einer anderen Ausführungsform weist der Kontaktkörper eine Art schiefe Ebene auf. In wiederum einer anderen Ausführungsform weisen Klemmmittel und Kontaktkörper beide eine Art schiefe Ebene auf. Die schiefe Ebene erstreckt sich in einer Ausführungsform um den gesamten Umfang der Klemmmittel und/oder des Kontaktkörpers. In anderen Ausführungsformen erstreckt sich die schiefe Ebene nur teilweise um den Umfang. Die Klemmmittel umgeben umfänglich den Kontaktkörper und klemmen diesen nach innen zu dem Kontakt hin. In anderen Ausführungsformen ist eine Umkehrung des Prinzips ausgeführt, in dem beispielsweise bei einem Kontakt mit Ausnehmung eine Klemmung nach außen bewirkt wird.

Vorzugsweise ist vorgesehen, dass zwischen Kontaktkörper und Klemmmittel eine Feder-Speicher-Einheit angeordnet ist, um ein federbeaufschlagtes Klemmen zu bewirken. Bei einem Bewegen des Klemmmittels in Längsrichtung wird zum Klemmen die Feder-Speicher-Einheit komprimiert, wodurch eine Federenergie gespeichert ist. Bei einer Lösung der Verbindung wird die Federenergie freigesetzt und bewegt das Klemmmittel in Längsrichtung entgegengesetzt. Auf diese Weise ist eine Rückmeldung aufgrund einer Federkraft gegeben. Um das Klemmmittel in einer die Feder-Speicher-Einheit komprimierenden Position zu halten, sind in einer Ausführungsform Arretiermittel vorgesehen. In anderen Ausführungsformen wird das Klemmmittel durch einen Aktuator oder dergleichen gehalten.

In einer weiteren vorteilhaften Ausgestaltung der Erfindung ist vorgesehen, dass ein Gehäuse zur Aufnahme der Klemmmittel und/oder des Kontaktkörpers vorgesehen ist. Das Gehäuse ist dabei als Außengehäuse ausgebildet. Eine Außenkontur ist an den jeweiligen Einsatzzweck anpassbar und für Kundenwünsche individuell einstellbar.

Entsprechend ist in noch einer weiteren Ausführungsform der Erfindung vorgesehen, dass eine Gehäuseaußenkontur komplementär an eine den Kontakt aufweisende Kontur einer Relaiseinheit angepasst ist. Ist der Kontakt beispielsweise von einer Wandung umgeben, so ist das Gehäuse an die entsprechende Wandung anpassbar.

Zudem sieht eine weitere Ausführungsform der vorliegenden Erfindung vor, dass das Gehäuse und der Kontaktkörper ortsfest zueinander ausgebildet sind. Gehäuse und Klemmmittel sind in einer Ausführungsform einteilig, das heißt integriert, ausgebildet. In anderen Ausführungsformen sind Gehäuse und Klemmmittel mehrteilig ausgebildet, beispielsweise zweiteilig. Der Kontaktkörper ist in einer Ausführungsform einteilig ausgebildet. In anderen Ausführungsformen ist der Kontaktkörper mehrteilig ausgeführt. Das Klemmmittel ist stets relativ zu dem Kontaktkörper bewegbar, insbesondere in Längsrichtung verschiebbar. Bevorzugt umfasst die Prüfungseinrichtung einen Kontaktkörper, ein Gehäuse und ein Klemmmittel.

Auch ist in einer weiteren vorteilhaften Ausgestaltung vorgesehen, dass ein Anschluss für einen Aktuator vorgesehen ist, um die Prüfungseinrichtung über den Aktuator zu bedienen. Der Anschluss ist bevorzugt an dem Klemmmittel ausgebildet, da dieses relativ zu dem Gehäuse und dem Kontaktkörper bewegbar ist. So wird in einem Anwendungsbeispiel das Gehäuse mit dem Kontaktkörper an dem entsprechenden Relais angesetzt, sodass der entsprechende Kontakt in der Ausnehmung aufgenommen ist. Dann wird der Aktuator betätig und das Klemmmittel bewegt sich relativ zu den anderen Bauteilen in Richtung Kontakt, sodass eine klemmende Verbindung von Kontakt und Kontaktkörper realisiert ist. Die Bewegung des elastischen Abschnitts des Kontaktkörpers erfolgt im Wesentlichen senkrecht zu den Oberflächen des Kontakts, sodass eine Reibung aufgrund einer Relativbewegung von Kontaktkörper und Kontakt in Längsrichtung vermieden ist.

Ein weiter bevorzugtes Ausführungsbeispiel sieht vor, dass bei einem Verfahren zum elektrischen Prüfen von in eine Längsrichtung hervorragenden Kontakten, insbesondere zur Leistungsprüfung bei Startern, die Schritte umfasst sind: Kontaktieren des Kontakts mit einem Kontaktkörper und Übertragen von elektrischen Signalen zwischen dem Kontakt und dem Kontaktkörper. Bevorzugt umfasst das Kontaktieren den Schritt Klemmen des Kontakts mit dem Kontaktkörper mittels mindestens einem Klemmmittel, wobei die Klemmmittel in Längsrichtung relativ zu dem Kontakt und/oder dem Kontaktkörper bewegt werden, um durch eine Bewegung der Klemmmittel eine klemmende Kontaktierung des aufgenommenen Kontakts quer zu der Längsrichtung zu bewirken. Mit diesem Verfahren wird ein Starter während der Schluss- und Leistungsprüfung in der Starterfertigung innerhalb einer Taktzeit von etwa sechs Sekunden sicher kontaktiert. In der Zeit wird ein Strom von 1000 A übertragen. Mittels des erfindungsgemäßen Verfahrens wird eine Prüfung ohne Kenntnis über die genaue Relaislage durchführbar. Die Kontaktflächen werden entsprechend groß ausgelegt, sodass die Stromdichte bei der Übertragung in einem unkritischen Bereich liegt. Das Verfahren ist für hohe Stromstärken durchführbar.

Nicht zuletzt sieht eine weitere vorteilhafte Ausführungsform der vorliegenden Erfindung eine Verwendung der Prüfungseinrichtung zur elektrischen Prüfung von in eine Längsrichtung hervorragenden Kontakten, insbesondere zur Leistungsprüfung bei Startern vor. Durch die Verwendung der Prüfungseinrichtung sind geringe Taktzeiten aufgrund einer leichten und einfachen Kupplung mit dem Startermotor realisierbar. Durch die spezielle Ausformung der Prüfungseinrichtung sind entsprechend große Kontaktflächen realisiert, die für ein Übertragung von hohen Stromstärken ausgelegt sind, ohne dass es zu kritischen Stromdichten bei der Übertragung kommt.

### Kurze Beschreibung der Zeichnungen

Ausführungsbeispiele der Erfindung sind in den Zeichnungen dargestellt und in der nachfolgenden Beschreibung näher erläutert. Es zeigen:
- Fig. 1: schematisch in einer Perspektivansicht eine Ausführungsform der Prüfungseinrichtung,
- Fig. 2: schematisch in einem Längsschnitt die Prüfungseinrichtung nach Fig. 1,
- Fig. 3: schematisch in einem Längsschnitt eine andere Ausführungsform einer Prüfungseinrichtung,
- Fig. 4: in einer Seitenansicht die Prüfungseinrichtung nach Fig. 3,
- Fig. 5: schematisch in einem weiteren Längsschnitt entlang der Schnittlinie A-A nach Fig. 4 die Prüfungseinrichtung nach Fig. 4,
- Fig. 6: schematisch in einer Perspektivansicht einen Kontaktkörper der Prüfungseinrichtung nach Fig. 3,
- Fig. 7: schematisch in einer Perspektivansicht eine Führungseinheit zum Führen der Klemmmittel relativ zu dem Kontaktkörper,
- Fig. 8: schematisch in einer Perspektivansicht ein Gehäuse mit eingesetztem Kontaktkörper und
- Fig. 9: schematisch in einer anderen Perspektivansicht das Gehäuse mit dem Kontaktkörper nach Fig. 8.

### Beschreibung des Ausführungsbeispiels

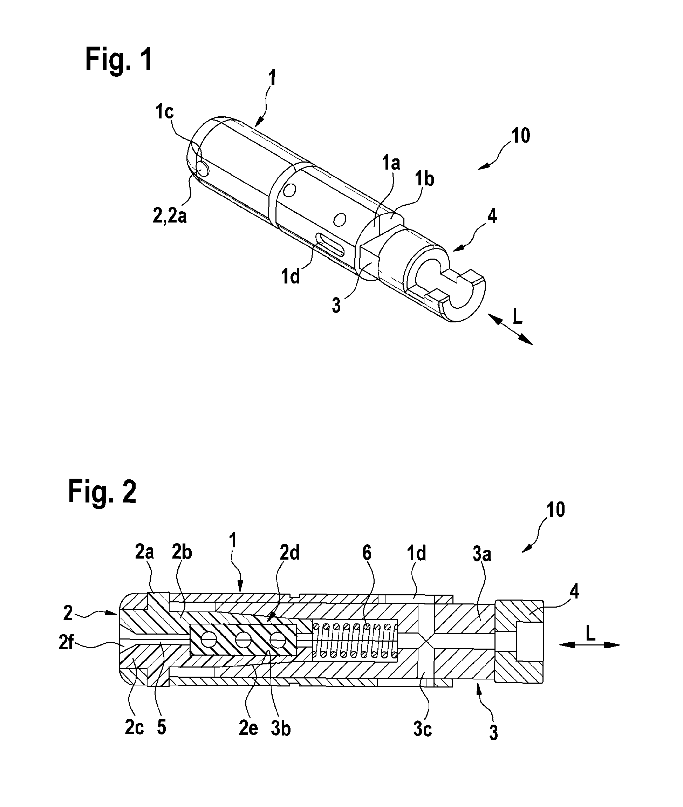

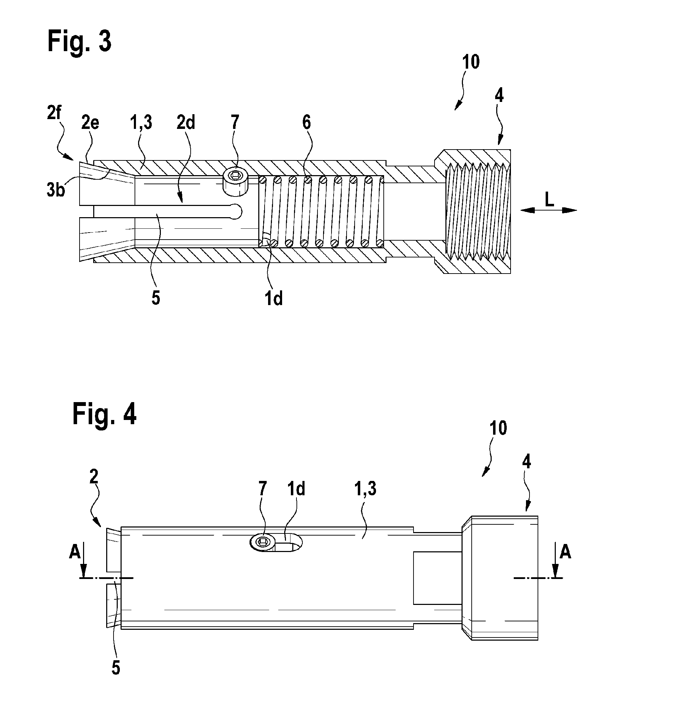

Fig. 1 und Fig. 2 zeigen schematisch eine Ausführungsform der Prüfungseinrichtung 10 in einer Perspektivansicht (Fig. 1) und in einem Längsschnitt (Fig. 2). Die Prüfungseinrichtung 10 umfasst ein Gehäuse 1, das in der dargestellten Ausführungsform zweiteilig ausgeführt ist. Entsprechend weist das Gehäuse 1 einen ersten Gehäuseteil 1a und einen zweiten Gehäuseteil 1b auf, die beide spiegelsymmetrisch zueinander ausgebildet sind. Das Gehäuse 1 weist eine Gehäusekontur auf, die an den jeweiligen Einsatzzweck angepasst ist. In der vorliegenden Ausführungsform nach Fig. 1-2 ist das Gehäuse 1 hülsenartig ausgebildet und umfasst im Inneren einen Kontaktkörper 2 und ein bewegbar gelagertes Klemmmittel 3 (beide detailliert in Fig. 2 dargestellt). Zur ortsfesten Festlegung des Kontaktkörpers 2 an dem Gehäuse 1 weist das Gehäuse 1 Öffnungen 1c auf, in welche Anformungen 2a des Kontaktkörpers 2 hineinragen. Des weiteren weist das Gehäuse 1 Langlöcher 1d auf, welche als Führungsschlitze für das Klemmmittel 3 dienen. Das Klemmmittel 3 ist als Klemmkörper 3a ausgebildet und ragt mit einem Ende aus dem Gehäuse 1 heraus. An dem herausragenden Ende des Klemmmittels 3 ist ein Anschluss 4 für eine Anbindung, beispielsweise an einen hier nicht dargestellten Aktuator ausgebildet. Über diesen Anschluss 4 ist das Klemmmittel 3 relativ zu dem Gehäuse 1 und dem Kontaktkörper 2 in eine Längsrichtung L bewegbar. Wie Fig. 2 zeigt, ist der Kontaktkörper 2 zweiteilig mit zwei spiegelsymmetrisch ausgebildeten Kontaktkörperteilen 2b, 2c ausgebildet. In dem Kontaktkörper 2 ist eine Kontaktausnehmung 5 ausgebildet. Die Kontaktausnehmung 5 ist in dem Ausführungsbeispiel nach Fig. 1 und 2 als Innenkontaktausnehmung ausgebildet, welche den Kontakt bei Prüfung umfänglich zumindest teilweise umgibt. Entsprechend weist die Innenkontaktausnehmung eine Innenkontur auf, die ähnlich zu einer Außenkontur des Kontakts ausgebildet ist, sodass der Kontakt unter Spiel in der Innenkontur aufnehmbar ist. Um den Kontakt in der Kontaktausnehmung 5 zu klemmen, weist der Kontaktkörper 2 einen elastischen Abschnitt 2d auf. Der elastische Abschnitt 2d ist aus einem elastischeren Material als der restliche Kontaktkörper 2 ausgebildet, insbesondere aus Moosgummi, sodass zumindest in diesem Bereich eine Klemmung des Kontakts durch Verengen der Kontaktaufnahme 5 für den Kontakt erfolgen kann. Um eine Klemmung des Kontakts zu bewirken, weist der Kontaktkörper 2 an seiner Außenkontur eine Art schiefe Ebene 2e auf, die hier aufgrund der rotationssymmetrischen Außenkontur als kegelförmiger Abschnitt ausgebildet ist. Dazu korrespondierend weist das als hülsenartig den Kontaktkörper 2 umgebende Klemmmittel 3, genauer der Klemmkörper 3 an seiner Innenkontur ebenfalls eine Art schiefe Ebene 3b auf, welche aufgrund der rotationssymmetrischen Innenkontur als kegelförmiger Abschnitt ausgebildet ist. Die schiefen Ebenen 2e, 3b sind derart ausgebildet, dass bei einem Zusammenschieben von Klemmkörper 3a und Kontaktkörper 2 der elastische Abschnitt 2d komprimiert wird, wodurch die Kontaktaufnahme 5 verengt wird und der aufgenommenen Kontakt in der Kontaktaufnahme 5 geklemmt wird. Die schiefen Ebenen 2e, 3b und die Kontur der Kontaktaufnahme 5 sind so ausgebildet, dass eine an die Kontur des Kontakts angepasste Klemmung erfolgt, die insbesondere eine möglichst gleichmäßige Lastverteilung an der Oberfläche des Kontakts bewirkt. Diese gleichmäßige Lastverteilung wird insbesondere durch Erzeugen eines möglichst großen Kontaktbereichs zwischen Kontakt und Kontaktkörper 2 bewirkt. Um eine Klemmung des Kontakts aufzuheben, werden Kontaktkörper 2 und Klemmmittel 3 auseinander bewegt. Das Auseinanderbewegen wird durch eine zwischen Kontaktkörper 2 und Klemmmittel 3 angeordnete Feder-Speicher-Einheit 6 bewirkt. Die in dem Ausführungsbeispiel nach Fig. 1 und 2 als Druckfeder ausgebildete Feder-Speicher-Einheit 6 wird bei einem Klemmen komprimiert und entspannt sich bei einem Aufheben der Klemmung. In dem dargestellten Ausführungsbeispiel erfolgt somit ein Klemmen durch einen Aktuator oder dergleichen entgegen der Kraft der Feder-Speicher-Einheit 6. Bei Wegfall einer Kraftaufbringung durch den Aktuator wird der Kontakt durch die in der Feder-Speicher-Einheit 6 gespeicherte Kraft wieder freigegeben. Zusätzlich werden eine Klemmung und ein Aufheben der Klemmung durch eine geeignete Neigung der schiefen Ebenen unterstützt. Als besonders vorteilhaft haben sich Winkel in dem Bereich von 5° bis 25°, insbesondere um 15° herausgestellt. Mit einem Winkel von etwa 15° ist ein ungewolltes Blockieren einer Klemmung minimiert. Für andere Anwendungen sind andere Winkel vorteilhaft. Zudem ist eine Blockierung durch eine Führung des Klemmmittels 3 gewährleistet. Hierzu weist der Klemmkörper 3a eine Querbohrung 3c auf, in welche ein hier nicht, jedoch in Fig. 3, dargestellter Führungsstift als Führungseinheit 7 eingesteckt wird. Dieser Führungsstift ragt über das Klemmmittel 3 in die vorgesehenen Langlöcher 1d des Gehäuses, sodass der Klemmkörper 3a über den Führungsstift in den Langlöchern 1d geführt ist. Um einen Kontakt auf einfache Weise in die Kontaktaufnahme 5 einzuführen, weist der Kontaktkörper 2 an seinen dem Kontakt zugewandten Enden eine Aufweitung 2f auf. Die Aufweitung 2f ist hier als fasenartige Verbreiterung der Kontaktaufnahme 5 ausgebildet. Mit der Aufweitung 2f ist der Kontakt leichter in die Kontaktaufnahme 5 einführbar. Gemäß dem in den Fig. 1 und 2 dargestellten Prinzip sind verschiedenste Ausführungen einer Prüfungseinrichtung 10 realisierbar. Ein weiteres Ausführungsbeispiel ist in den folgenden Fig. dargestellt.

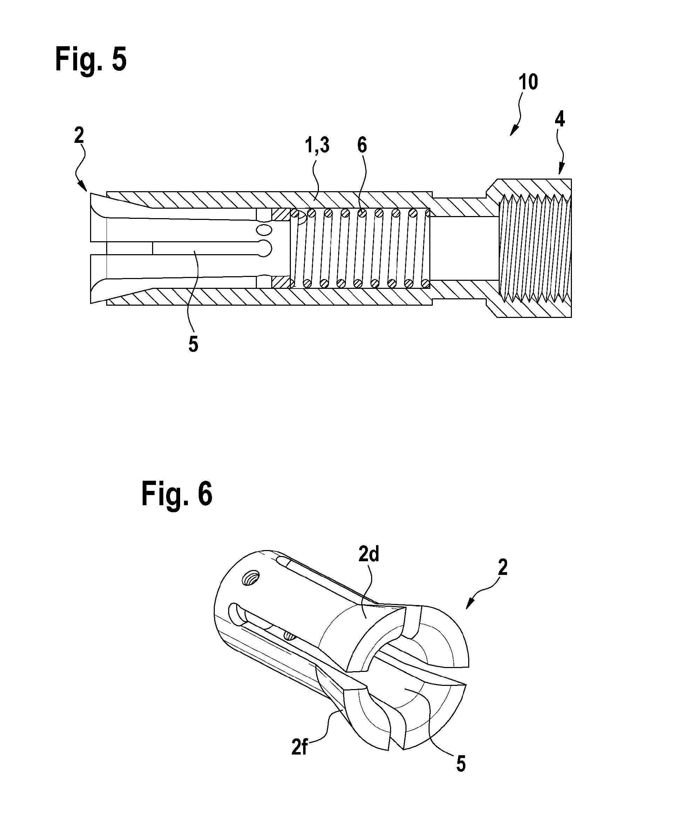

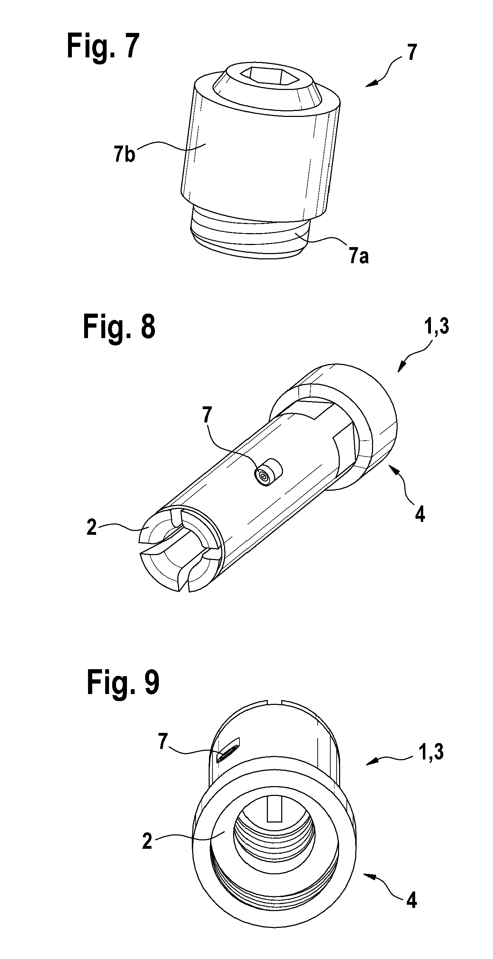

Die Fig. 3 bis 9 zeigen eine andere Ausführungsform einer Prüfungseinrichtung 10. Bei der Prüfungseinrichtung 10 nach Fig. 3 bis 9 sind Klemmmittel 3 und Gehäuse 1 integriert ausgebildet, das heißt, Klemmmittel 3 und Gehäuse 1 sind einteilig miteinander ausgebildet. Um nun einen Kontakt klemmend in der Kontaktaufnahme 5 aufzunehmen, wird der Kontaktkörper 2 mit der Aufweitung 2f über den Kontakt gesteckt, sodass der Kontakt sicher in der Kontaktaufnahme 5 angeordnet ist. Dann wird über den Anschluss 4 das Klemmmittel 3 relativ zu dem Kontaktkörper 2 bewegt, wobei das Klemmmittel 3 eine axial, das heißt in Längsrichtung L aufgebrachte Anpresskraft über die schiefen Ebenen 2e, 3b auf den Kontaktkörper 2 und dessen elastischen Abschnitt 2d überträgt. Der elastische Abschnitt 2d ist hier als Materialaussparung, genauer durch schlitzförmige Ausnehmungen, realisiert. Bei dem Aufbringen der Anpresskraft wird die Feder-Speicher-Einheit 6 komprimiert. Bei Aufheben der Anpresskraft dekomprimiert die Feder-Speicher-Einheit 6 entsprechend. An dem Kontaktkörper 2 ist eine Führungseinheit 7 mit Führungsstift angebracht, die in entsprechenden Langlöchern 1d des Gehäuses 1 aufgenommen ist, wie in Fig. 4 detailliert dargestellt. Der Kontaktkörper 2 ist detaillierter in Fig. 6 dargestellt. Die Führungseinheit 7 ist in Fig. 7 dargestellt. Fig. 8 und 9 zeigen detaillierter das Gehäuse 1 bzw. das Klemmmittel 3, die integriert ausgebildet sind.

Um eine Relativbewegung zwischen dem Kontakt und der Prüfungseinrichtung 10 zu verhindern, schließt die Prüfungseinrichtung 10 sich selbstständig beim Aufsetzen des Kontaktkörpers 2 auf den Kontakt, genauer auf eine Verstemmscheibe oder eine Mutter am Kontaktbolzen, je nach Relaisdeckel. Als Kontaktfläche stehen mit der Prüfungseinrichtung 10 neben Stirnflächen beispielsweise den Flächen auf der Mutter und der Verstemmscheibe, auch die Seitenflächen, beispielsweise die Gewindegänge des Bolzens zur Verfügung. Auf diese Weise wird eine größere Kontaktfläche, beispielsweise in Form eines Mehrpunktkontaktes erzielt. Die Baugröße der Prüfungseinrichtung 10 entspricht im Wesentlichen den bisherigen Kontaktierlösungen, wobei die Anschlussschnittstellen im Wesentlichen gleich ausgebildet sind, sodass hier keine Kompatibilitätsprobleme auftreten. Die Prüfungseinrichtung 10 weist am Einlass, genauer an der Aufweitung 2f vorzugsweise einen Fangradius auf, welcher die Abweichungen der Relaislage bzw. des Kontaktbolzens ausgleicht. Somit weist der vordere Bereich des Kontaktkörpers 2, d. h. die Aufweitung 2f, einen kegelförmigen Außenradius auf, der in dem Kontaktkörper 2 läuft. Beim Vorschub der Klemmmittel 3 durch einen Anschluss 3, beispielsweise einen vorhandenen Kontaktkopf, setzt die Prüfungseinrichtung 10 auf dem Relaisdeckel auf. Der Kontaktkörper 2 schiebt sich über den Kegelansatz und die Prüfungseinrichtung schließt sich sicher um den Kontakt. Durch das Überschieben des Kontaktkörpers 2 zum Schließen wird sichergestellt, dass ausreichend Druck auf die stirnseitigen Kontaktierflächen (Mutter oder Verstemmscheibe) des Kontakts ausgeübt wird, um einen optimalen Stromübergang zu gewährleisten. Das Lösen der Prüfungseinrichtung 10 wird durch eine Druckfeder in dem Gehäuse 1 und einem Kegelwinkel von 15° erleichtert. Die Führung der Prüfungseinrichtung 10 in dem Gehäuse 1 wird über zwei Gewindestifte 7a erreicht, um die eine kleine Hülse 7b mit Innengewinde geschraubt wird. Diese Hülsen 7b laufen in zwei Langlöchern 1d des Gehäuses 1. Die Materialauswahl ist von folgenden Gesichtspunkten abhängig: Verschleißfestigkeit zwischen Gehäuse 1 und Kontaktkörper 2, Beschädigungsfreiheit des Kontakts auch bei ungenauer Einführung, ausreichende Leitfähigkeit auch für hohe Stromstärken im Bereich von 1000 A, optimiertes Verhältnis zwischen Kosten und Standzeit.

## Patentansprüche

1. Prüfungseinrichtung (10) zur elektrischen Prüfung von in eine Längsrichtung (L) hervorragenden Kontakten, insbesondere zur Leistungsprüfung bei Startern, umfassend einen Kontaktkörper (2) zur Kontaktieren mit dem Kontakt, **dadurch gekennzeichnet, dass**
Klemmmittel (3) vorgesehen sind, die in Längsrichtung (L) relativ zu dem Kontakt und/oder dem Kontaktkörper (2) bewegbar sind, um durch eine Bewegung der Klemmmittel (3) eine klemmende Kontaktierung des aufgenommenen Kontakts quer zu der Längsrichtung (L) zu bewirken.

2. Prüfungseinrichtung (10) nach Anspruch 1, **dadurch gekennzeichnet, dass** der Kontaktkörper (2) eine Kontaktausnehmung (5) zur Aufnahme des Kontakts aufweist, wobei die Kontaktausnehmung (5) als Innenkontaktausnehmung ausgebildet ist, welche den Kontakt bei Prüfung umfänglich zumindest teilweise umgibt.

3. Prüfungseinrichtung (10) nach Anspruch 1 oder 2, **dadurch gekennzeichnet, dass**
die Innenkontaktausnehmung eine Innenkontur aufweist, die ähnlich zu einer Außenkontur des Kontakts ausgebildet ist, sodass der Kontakt unter Spiel in der Innenkontur aufnehmbar ist.

4. Prüfungseinrichtung (10) nach einem der vorherigen Ansprüche 1 bis 3, **dadurch gekennzeichnet, dass**
die Kontaktausnehmung (5) an einem dem Kontakt zugewandten Stirnbereich eine Aufweitung (1d) zur Aufnahme des Kontakts aufweist.

5. Prüfungseinrichtung (10) nach einem der vorherigen Ansprüche 1 bis 4, **dadurch gekennzeichnet, dass**
der Kontaktkörper (2) einen elastischen Abschnitt (2d) im Bereich der Kontaktaufnahme (5) aufweist, um den aufgenommenen Kontakt bei Betätigung zu klemmen.

6. Prüfungseinrichtung (10) nach einem der vorherigen Ansprüche 1 bis 5, **dadurch gekennzeichnet, dass**
der Kontaktkörper (2) und die Klemmmittel (3) über mindestens eine schräge Fläche an dem elastischen Abschnitt (1d) miteinander kontaktierend gekoppelt sind, sodass durch eine Relativbewegung der Klemmmittel (3) zu dem Kontaktkörper (2) eine Klemmung des aufgenommenen Kontakts bewirkt oder aufgehoben ist.

7. Prüfungseinrichtung (10) nach einem der vorherigen Ansprüche 1 bis 6, **dadurch gekennzeichnet, dass**
zwischen Kontaktkörper (2) und Klemmmittel (3) eine Feder-Speicher-Einheit (6) angeordnet ist, um ein federbeaufschlagtes Klemmen zu bewirken.

8. Prüfungseinrichtung (10) nach einem der vorherigen Ansprüche 1 bis 7, **dadurch gekennzeichnet, dass**
ein Gehäuse (1) zur Aufnahme der Klemmmittel (3) und/oder des Kontaktkörpers (2) vorgesehen ist.

9. Prüfungseinrichtung (10) nach einem der vorherigen Ansprüche 1 bis 8, **dadurch gekennzeichnet, dass**
eine Gehäuseaußenkontur komplementär an eine den Kontakt aufweisende Kontur einer Relaiseinheit angepasst ist.

10. Prüfungseinrichtung (10) nach einem der vorherigen Ansprüche 1 bis 9, **dadurch gekennzeichnet, dass**
das Gehäuse (1) und der Kontaktkörper (2) ortsfest zueinander ausgebildet sind.

11. Prüfungseinrichtung (10) nach einem der vorherigen Ansprüche 1 bis 10, **dadurch gekennzeichnet, dass**
ein Anschluss (4) für einen Aktuator vorgesehen ist, um die Prüfungseinrichtung (10) über den Aktuator zu bedienen.

12. Verfahren zum elektrischen Prüfen von in eine Längsrichtung (L) hervorragenden Kontakten, insbesondere zur Leistungsprüfung bei Startern, umfassend die Schritte Kontaktieren des Kontakts des Starters mit einem Kontaktkörper und
Übertragen von elektrischen Signalen zwischen dem Kontakt und dem Kontaktkörper, **dadurch gekennzeichnet, dass**
das Kontaktieren den Schritt
Klemmen des Kontakts mit dem Kontaktkörper mittels mindestens eines Klemmmittels umfasst, wobei die Klemmmittel (3) in Längsrichtung (L) relativ zu dem Kontakt und/oder dem Kontaktkörper (2) bewegt werden, um durch eine Bewegung der Klemmmittel (3) eine klemmende Kontaktierung des aufgenommenen Kontakts quer zu der Längsrichtung (L) zu bewirken.

13. Verwendung einer Prüfungseinrichtung (10) nach einem der vorherigen Ansprüche 1 bis 11 zur elektrischen Prüfung von in eine Längsrichtung (L) hervorragenden Kontakten, insbesondere zur Leistungsprüfung bei Startern.
